# EUROPEAN PATENT APPLICATION

(11) **EP 4 723 811 A1**
(43) Date of publication of application: **08.04.2026**
(21) Application number: 24830174.9
(22) Date of filing: 09.05.2024
(51) Int. Cl.: H05K 1/11, H05K 1/02

(54) **VIA HOLE STRUCTURE, SIGNAL VIA HOLE IMPEDANCE ADJUSTING METHOD, AND PRINTED CIRCUIT BOARD**

(30) Priority: 30.06.2023 CN 202310802851
(71) Applicant: ZTE CORPORATION, Shenzhen, Guangdong 518057 (CN)
(72) Inventor: LI, Jinlong, Shenzhen, Guangdong 518057 (CN); WEI, Zhongmin, Shenzhen, Guangdong 518057 (CN)
(74) Representative: Ziebig Hengelhaupt Intellectual Property Attorneys Patentanwaltskanzlei PartGmbB
(86) International application number: PCT/CN2024/091830
(87) International publication number: WO 2025/001526

(57) **Abstract**

The present application relates to the technical field of communications, and discloses a via hole structure, a signal via hole impedance adjusting method, and a printed circuit board. The via hole structure comprises: at least one signal via hole; and at least one terminal, wherein one terminal is electrically connected to one signal via hole.

## Description

### CROSS REFERENCE TO RELATED APPLICATIONS

This application claims priority to Chinese Patent Application No. 202310802851.7 filed on June 30, 2023, entitled "VIA HOLE STRUCTURE, SIGNAL VIA HOLE IMPEDANCE ADJUSTING METHOD, AND PRINTED CIRCUIT BOARD", the entirety of which is incorporated herein by reference.

### TECHNICAL FIELD

The present application belongs to the field of communication technology, and particularly relates to a via hole structure, a signal via hole impedance adjusting method and a printed circuit board.

### BACKGROUD

With the advent of the era of big data, the single-channel signal rate of digital chips is constantly increasing to meet the demands of massive data communication and interaction, however, the higher the signal rate, the larger the channel bandwidth required for transmission. The signal bandwidth may be understood as a difference between the highest frequency and the lowest frequency of the signal in the signal spectrogram, in other words, the signal bandwidth is the frequency range possessed by the signal.

Via holes are indispensable components in modern communication products. In order to increase the signal rate, the current mainstream solution is to adjust the distance between the differential via holes, the distance between the ground hole and the differential via holes, and the size of the anti-pad of the differential via holes, so as to reduce the via hole impedance.

However, due to the Conductive Anodic Filament (CAF) effect, the distance between via holes of different networks cannot be less than a certain value. At present, the process requires that the spacing of hole walls to be greater than 0.5 mm. Therefore, adjusting impedance by controlling the distance between via holes is limited.

On the other hand, the size of an anti-pad cannot be sufficiently small due to the limitation of processing capacity, therefore, adjusting impedance by the size of anti-pad of differential via holes is also subject to certain limitations. It can be seen that in the related art, conventional methods have limited ability to adjust the impedance of via holes when the impedance of differential via holes is high, which affects the signal rate.

### SUMMARY

An object of embodiments of the present application is to provide a via hole structure, a signal via hole impedance adjusting method, and a printed circuit board, which can solve the problem of high via hole impedance of a printed circuit board (PCB) in a high-speed digital product.

In a first aspect, an embodiment of the present application provides a via hole structure, the via hole structure includes: at least one signal via hole; and at least one terminal, wherein one terminal is electrically connected to one signal via hole.

In one embodiment of the first aspect, only one signal via hole is electrically connected to the at least one terminal.

In one embodiment of the first aspect, a plurality of signal via holes are electrically connected to the at least one terminal, and one terminal is electrically connected to one signal via hole.

In one embodiment of the first aspect, the one signal via hole is electrically connected to a plurality of terminals.

In one embodiment of the first aspect, the plurality of terminals are mutually isolated from each other.

In one embodiment of the first aspect, the plurality of terminals are electrically connected together.

In one embodiment of the first aspect, the terminal is of a rectangular-ring structure.

In one embodiment of the first aspect, the terminal is fixedly connected to an outer wall of the signal via hole.

In a second aspect, an embodiment of the present application provides a signal via hole impedance adjusting method, applied to the via hole structure of the first aspect, the method includes: determining a target size of a terminal in the via hole structure based on a target impedance value; and adjusting a size of the terminal in the via hole structure to the target size according to the target size, such that an impedance value of the via hole structure reaches the target impedance value.

In one embodiment of the second aspect, after adjusting a size of the terminal in the via hole structure to the target size according to the target size, the method further includes: after adjusting a size of the terminal in the via hole structure to the target size, upon the condition that an impedance value of the via hole structure does not reach the target impedance value, adjusting at least one of a first distance between two signal differential holes in the via hole structure, a second distance between a ground hole and a signal via hole in the via hole structure, and a size of an anti-pad in the via hole structure, such that the impedance value of the via hole structure reaches the target impedance value.

In a third aspect, an embodiment of the present application provides a printed circuit board including the via hole structure of the first aspect.

In a fourth aspect, an embodiment of the present application provides a communication device including the printed circuit board of the third aspect.

In an embodiment of the present application, there is provided a via hole structure, the via hole structure includes: at least one signal via hole; and at least one terminal, wherein one terminal is electrically connected to one signal via hole, the impedance of the signal via hole can be adjusted by adjusting the size and number of the terminals, and the size of an anti-pad of a differential via hole does not need to be adjusted, thereby solving the problem that the capability of adjusting the impedance of the via hole is limited when the impedance of the differential via hole is relatively high.

### BRIEF DESCRIPTION OF THE DRAWINGS

FIG. 1a is a schematic structural diagram of a via hole structure in the related art;
FIG. 1b is a schematic structural diagram of another via hole structure in the related art;
FIG. 2 is a schematic structural diagram of a via hole structure provided by an embodiment of the present application;
FIG. 3a is a schematic structural diagram of another via hole structure provided by an embodiment of the present application;
FIG. 3b is a schematic structural diagram of yet another via hole structure provided by an embodiment of the present application;
FIG. 4a is a schematic structural diagram of still another via hole structure provided by an embodiment of the present application;
FIG. 4b is a schematic structural diagram of still another via hole structure provided by an embodiment of the present application;
FIG. 5 is a schematic flow chart of a signal via hole impedance adjusting method provided by an embodiment of the present application; and
FIG. 6 is a comparison graph of simulated impedance of a via hole structure according to an embodiment of the present application and a via hole structure according to the prior art.

### DETAILED DESCRIPTION

Technical solutions in embodiments of the application will be described clearly and thoroughly below with reference to the accompanying drawings in embodiments of the application. Obviously, the embodiments described are part of the embodiments of the application rather than all of the embodiments. All other embodiments obtained by a person skilled in the art without creative work based on embodiments in the application fall within the scope of the application.

The terms "first", "second", and the like in the description and in the claims of the application are used to distinguish between similar objects rather than describing a specific order or a sequence. It is to be understood that data used in such a way may be interchanged where appropriate, whereby embodiments of the application can be implemented in an order other than those illustrated or described herein, the objects distinguished by "first", "second", etc., are generally of one type, and the number of objects is not limited, for example, a first object may refer to one or more first objects. In addition, "and/or" in the description and claims indicates at least one of the objects connected therewith, and the character "/" generally indicates that the objects associated therewith are in an "or" relationship.

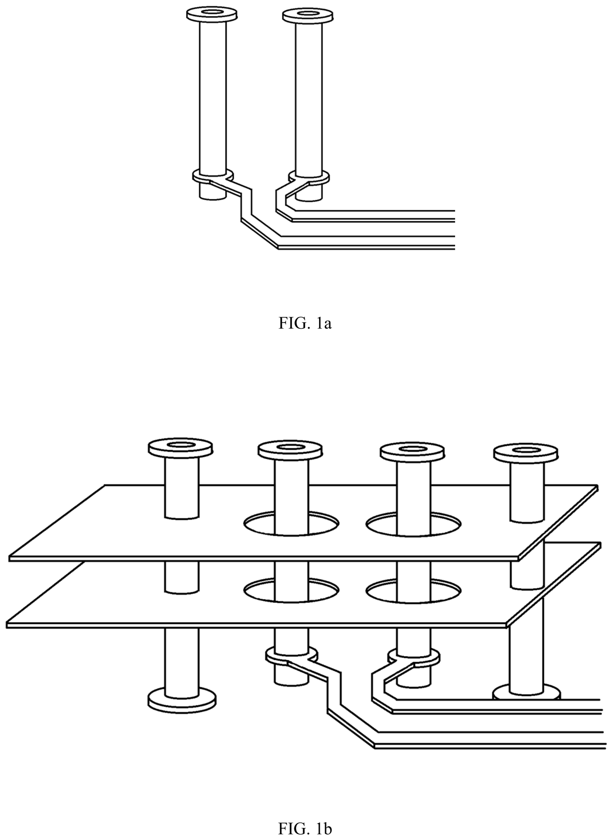

In the related art, in addition to adjusting the distance between two differential holes as shown in FIG. 1a, the impedance adjustment of differential via holes may further include adjusting the distance between the ground hole and the differential hole as shown in FIG. 1b, as well as the size of an anti-pad of the differential via hole. With the continuous increase of the signal rate, the dielectric constant of sheets used in high-speed products becomes smaller and smaller, as a result, the impedance of the signal via hole becomes higher and higher. If it is desirable to reduce the via impedance, it needs to shorten the distance between signal via holes and the distance between the signal via hole and the ground hole, as well as reduce the size of the anti-pad of the signal via hole. However, due to the CAF effect, the distance between via holes of different networks cannot be less than a certain value. At present, the process requires that the spacing of hole walls to be greater than 0.5 mm. Therefore, adjusting impedance by controlling the distance between via holes is limited. On the other hand, the size of an anti-pad cannot be sufficiently small due to the limitation of processing capacity. Therefore, conventional methods have limited ability to adjust the impedance of via holes when the impedance of a differential via hole is high. In view of this problem, an embodiment of the present application provides an improved via hole structure, in addition to a signal via hole, a terminal is added to the signal via hole, and the terminal exhibits capacitive characteristics, therefore, the via hole impedance can be reduced. In addition, a capacitive terminal can break through the CAF limitation, so as to reduce the equivalent distance between two signal via holes, thereby reducing impedance of via holes.

The via hole structure, signal via hole impedance adjusting method, printed circuit board and communication device provided by embodiments of the application will be described in detail by specific embodiments and application scenarios thereof with reference to the accompanying drawings.

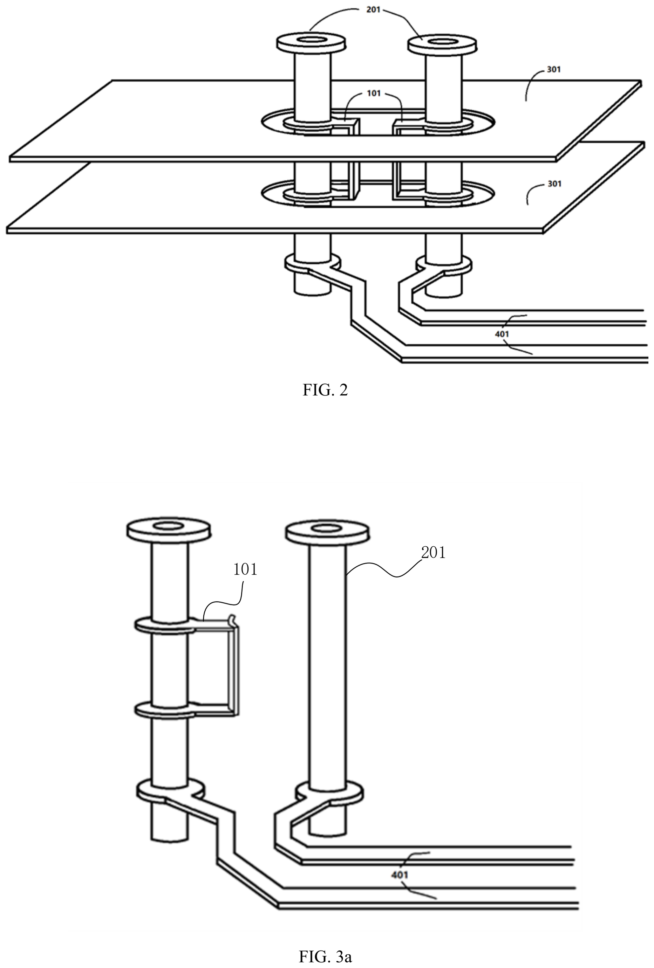

FIG. 2 is a schematic structural diagram of a via hole structure provided by an embodiment of the present application.

As shown in FIG. 2, an embodiment of the present application provides a via hole structure, the via hole structure includes: at least one signal via hole 201; and at least one terminal 101, wherein one terminal 101 is electrically connected to one signal via hole 201.

The terminal 101 in this via hole structure exhibits capacitive characteristics, thereby reducing the impedance of the signal via hole 201. Specifically, by adjusting the size of the terminal 101, the impedance of the entire signal via hole 201 is further adjusted without adjusting the size of the anti-pad of the signal via hole. In addition, the terminal 101 can break through the CAF limitation, so as to reduce the equivalent distance between two signal via holes 201, thereby reducing the impedance of the signal via hole 201.

It should be noted that the shape of the terminal 101 in embodiments of the present application is not limited.

In an embodiment of the present application, as shown in FIG. 2, the via hole structure may further include a conductive layer 301 and a transmission line 401.

In an embodiment of the present application, there is provided a via hole structure, the via hole structure includes: at least one signal via hole 201; and at least one terminal 101, wherein one terminal 101 is electrically connected to one signal via hole 201. Therefore, the impedance of the entire signal via hole 201 can be adjusted by adjusting the size of the terminal 101, in addition, the terminal 101 can break through the CAF limitation, so as to reduce the equivalent distance between two signal via holes 201, thereby reducing the impedance of the signal via hole 201.

FIG. 3a is a schematic structural diagram of another via hole structure provided by an embodiment of the present application.

As shown in FIG. 3a, an embodiment of the present application provides a via hole structure, in the via hole structure, only one signal via hole 201 is electrically connected to the at least one terminal 101.

In an embodiment of the present application, it can be seen that, in the via hole structure, only one signal via hole 201 is electrically connected to at least one terminal 101, and the other signal via hole 201 is not electrically connected to the terminal 101.

In one implementation of this embodiment, as shown in FIG. 3a, specifically, only one signal via hole 201 is electrically connected to one terminal 101, and the other one signal via hole 201 is not electrically connected to the terminal 101.

In another implementation of this embodiment, alternatively, only one signal via hole 201 may be electrically connected to two or more terminals 101, and the other one signal via hole 201 is not electrically connected to the terminal 101.

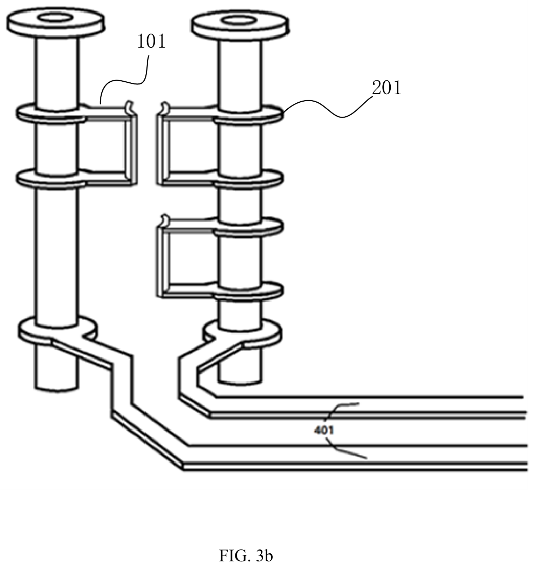

FIG. 3b is a schematic structural diagram of yet another via hole structure provided by an embodiment of the present application.

As shown in FIG. 3b, an embodiment of the present application provides a via hole structure, in the via hole structure, a plurality of signal via holes 201 are electrically connected to the at least one terminal 101, and one terminal 101 is electrically connected to one signal via hole 201.

In an embodiment of the present application, as shown in FIG. 3b, in the via hole structure, a plurality of signal via holes 201 are electrically connected to at least one terminal 101, and one terminal 101 is electrically connected to one signal via hole 201, that is to say, one terminal 101 can be electrically connected to only one signal via hole 201, whereas one signal via hole 201 may be electrically connected to at least one terminal 101, and in the plurality of signal via holes 201, multiple signal via holes 201 may be electrically connected to the terminal 101.

In one implementation of this embodiment, as shown in FIG. 3b, the via hole structure may also consist of two signal via holes 201 and three terminals 101, specifically, one signal via hole 201 is electrically connected to two terminals 101, and the other one signal via hole 201 is electrically connected to one signal via hole 201.

In another implementation of this embodiment, as shown in FIG. 2, the via hole structure may also consist of two signal via holes 201 and two terminals 101, specifically, one signal via hole 201 is electrically connected to one terminal 101, and the other one signal via hole 201 is electrically connected to one signal via hole 201.

It should be noted that, in an embodiment of the present application, in addition to ensuring that one terminal 101 is electrically connected to one signal via hole 201, other signal via holes 201 are electrically connected to at least one terminal 101, which may be electrically connected to one terminal 101 as shown in FIG. 2, or may be electrically connected to two terminals 101 as shown in FIG. 3b. Similarly, the signal via hole 201 may also be electrically connected to three, four or more terminals 101, which is not limited in specific embodiments of the present application.

In an embodiment of the present application, one signal via hole 201 is electrically connected to a plurality of terminals 101.

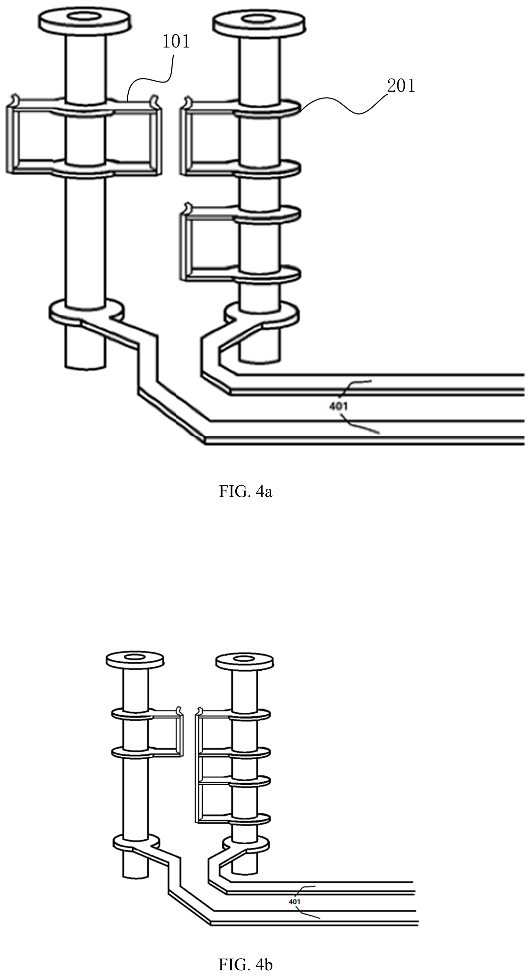

In one implementation of an embodiment of the present application, as shown in FIG. 3b, the signal via hole 201 on the right is electrically connected to two terminals 101. Alternatively, as shown in FIG. 4a, two signal via holes 201 are both electrically connected to two terminals 101.

In an embodiment of the present application, as shown in FIG. 4a, the orientation of the terminal 101 on the signal via hole 201 may be set arbitrarily.

In an embodiment of the present application, optionally, upon the condition that one signal via hole 201 is electrically connected to a plurality of terminals 101, the plurality of terminals 101 are mutually isolated from each other, as shown in FIG. 3b and FIG. 4a.

Alternatively, upon the condition that one signal via hole 201 is electrically connected to a plurality of terminals 101, the plurality of terminals 101 may also be electrically connected together, as shown in FIG. 4b.

In an embodiment of the present application, the terminal 101 may be of a rectangular-ring structure. Optionally, the terminal 101 is fixedly connected to an outer wall of the signal via hole 201. For example, in FIG. 2 to FIG. 4b, one terminal 101 may adopt a rectangular-ring structure, and each terminal 101 may be fixedly connected to an outer wall of the signal via hole 201 by means of electroplating.

In an embodiment of the present application, therefore, the impedance of the entire signal via hole 201 can be adjusted by adjusting the size of the terminal 101. In addition, the terminal 101 can break through the CAF limitation, so as to reduce the equivalent distance between two signal via holes 201, thereby reducing the impedance of the signal via hole 201 and improving the quality of signals.

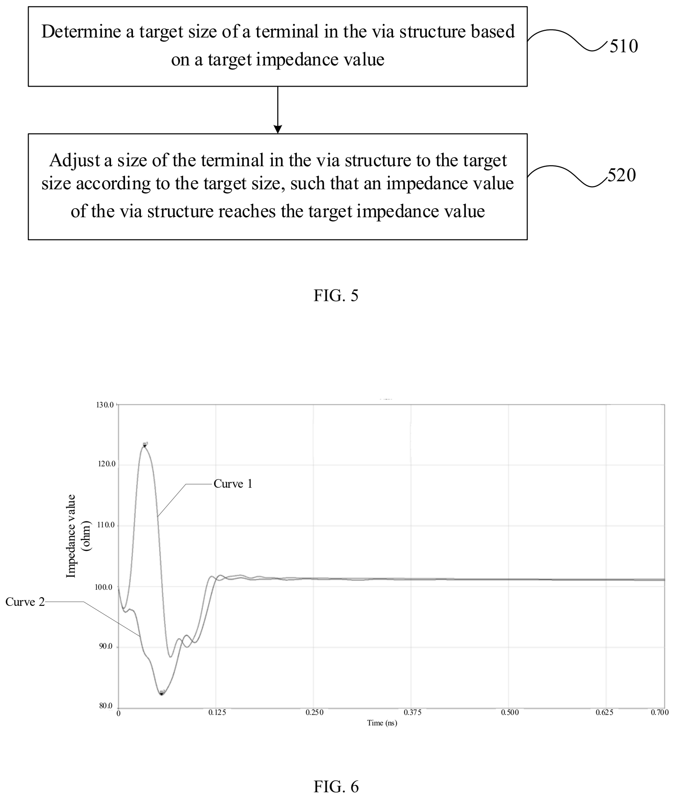

FIG. 5 is a schematic flow chart of a signal via hole impedance adjusting method provided by an embodiment of the present application.

The method is applied to any of the above-mentioned via hole structures, as shown in FIG. 5, the method mainly includes the following steps:
S510: a target size of a terminal in the via hole structure is determined based on a target impedance value.

In an embodiment of the present application, there is provided a signal via hole impedance adjusting method. In order to adjust the impedance of a signal via hole, firstly, a target impedance value should be determined, then a target size of a terminal in the via hole structure is determined based on a target impedance value.

Since the terminal exhibits capacitive characteristics, the terminal can reduce the impedance of the signal via hole. When the impedance is relatively large, that is, the target impedance value is relatively large, the target size of the terminal in the via hole structure will also be set relatively large; when the impedance is relatively small, that is, the target impedance value is relatively small, the target size of the terminal in the via hole structure is also set relatively small.

In specific applications, the sizes of terminals corresponding to individual impedance values can be obtained by three-dimensional modeling and simulation, and a correlation between impedance values and sizes of terminals is established. In specific applications, a target size of a terminal in a via hole structure can be obtained according to a target impedance value.

S520: a size of the terminal in the via hole structure is adjusted to the target size according to the target size, such that an impedance value of the via hole structure reaches the target impedance value.

In an embodiment of the present application, there is provided a signal via hole impedance adjusting method. Since the impedance of the signal via hole can be reduced on the basis that the terminal exhibits capacitive characteristics; therefore, a terminal electrically connected to the signal via hole is disposed around the signal via hole, which plays a role of adjusting the impedance in the signal via hole.

In addition, the provided terminal can break through the CAF limitation, so as to reduce the equivalent distance between two signal via holes, thereby reducing impedance of signal via holes.

In an embodiment of the present application, after adjusting a size of the terminal in the via hole structure to the target size according to the target size, the method further includes: after adjusting a size of the terminal in the via hole structure to the target size, upon the condition that an impedance value of the via hole structure does not reach the target impedance value, adjusting at least one of a first distance between two signal differential holes in the via hole structure, a second distance between a ground hole and a signal via hole in the via hole structure, and an anti-pad size in the via hole structure, such that the impedance value of the via hole structure reaches the target impedance value.

In an embodiment of the present application, there is provided a signal via hole impedance adjusting method, which can solve the problem of high PCB via hole impedance in a high-speed digital product, reduce the via hole impedance and improve signal quality.

In addition, please refer to FIG. 6, which is a comparison graph of simulated impedance of a via hole structure according to an embodiment of the present application and a via hole structure according to the prior art. In the graph, the horizontal coordinate represents a signal transmission time, the unit is ns, the vertical coordinate represents an impedance value, and the unit is ohm. It can be seen from FIG. 6 that the simulated impedance of a via hole structure provided in an embodiment of the present application (curve 2) has better continuity compared with the simulated impedance of a via hole structure provided in the prior art (curve 1), the impedance in the prior art is too high, and the technique of the embodiment of the present application can reduce the impedance.

In addition, it can be seen from FIG. 6 that the impedance adjustment interval simulated by the embodiment of the present application is larger, which indicates that, in addition to the conductor layer, the impedance of the via hole at the position of the dielectric layer can also be adjusted.

An embodiment of the present application further provides a printed circuit board, the printed circuit board includes any of the above-mentioned via hole structures.

An embodiment of the present application further provides a communication device, the communication device includes the printed circuit board described above.

It should be noted that, as used herein, the terms "include", "comprise" or any other variations thereof are intended to cover a non-exclusive inclusion, such that a process, method, article, or apparatus that comprises a series of elements not only comprises those elements, but also comprises other elements that are not explicitly listed, or further comprises elements that are inherent to the process, method, article, or apparatus. Without further limitations, an element limited by "comprising a..." does not exclude the presence of other identical elements in the process, method, article, or device that comprises the element. In addition, it should be noted that the scope of the method and device in embodiments of this application is not limited to perform functions in the order shown or discussed, but may also include performing functions in a substantially simultaneous manner or in an opposite order according to the functions involved, for example, the described methods may be performed in a different order than described, and various steps may be added, omitted, or combined. Additionally, features described with reference to certain examples can be combined in other examples.

With the description of the above implementations, those skilled in the art can clearly understand that the above implementation methods can be effected via software and necessary general hardware platforms, as well as hardware, in many cases, the former is the preferred implementation. Based on such an understanding, the technical solutions of the present application essentially or the part contributing to the prior art may be embodied in the form of a software product.

Those skilled in the art will readily appreciate other embodiments of the present application after considering the description and practicing the application disclosed herein. The present application is intended to cover any variations, uses or adaptations of the present application, which follow the general principles of the present application and include common knowledge or customary technical means in the art that are not disclosed in the present application. The description and embodiments are to be considered as exemplary only, and the true scope and spirit of the present application are indicated by the claims.

It should be understood that the present application is not limited to the precise structures that are described above and shown in the drawings, and various modifications and changes may be made without departing from the scope thereof. The scope of the present application is limited only by the appended claims.

## Claims

1. A via hole structure, comprising:
at least one signal via hole; and
at least one terminal, wherein one terminal is electrically connected to one signal via hole.

2. The via hole structure according to claim 1, wherein only one signal via hole is electrically connected to the at least one terminal.

3. The via hole structure according to claim 1, wherein a plurality of signal via holes are electrically connected to the at least one terminal, and one terminal is electrically connected to one signal via hole.

4. The via hole structure according to any one of claims 1 to 3, wherein one signal via hole is electrically connected to a plurality of terminals.

5. The via hole structure according to claim 4, wherein the plurality of terminals are mutually isolated from each other.

6. The via hole structure according to claim 4, wherein the plurality of terminals are electrically connected together.

7. The via hole structure according to any one of claims 1 to 3, wherein the terminal is of a rectangular-ring structure.

8. The via hole structure according to any one of claims 1 to 3, wherein the terminal is fixedly connected to an outer wall of the signal via hole.

9. A signal via hole impedance adjusting method, applied to the via hole structure according to any one of claims 1 to 8, the method comprises:
determining a target size of a terminal in the via hole structure based on a target impedance value; and
adjusting a size of the terminal in the via hole structure to the target size according to the target size, such that an impedance value of the via hole structure reaches the target impedance value.

10. The method according to claim 9, wherein after adjusting a size of the terminal in the via hole structure to the target size according to the target size, the method further comprises:
after adjusting a size of the terminal in the via hole structure to the target size, upon the condition that an impedance value of the via hole structure does not reach the target impedance value, adjusting at least one of a first distance between two signal differential holes in the via hole structure, a second distance between a ground hole and a signal via hole in the via hole structure, and a size of an anti-pad in the via hole structure, such that the impedance value of the via hole structure reaches the target impedance value.

11. A printed circuit board, comprising the via hole structure according to any one of claims 1 to 8.

12. A communication device, comprising the printed circuit board according to claim 11.
